# EUROPÄISCHE PATENTANMELDUNG

(11) **EP 2 838 115 A1**
(43) Veröffentlichungstag der Anmeldung: **18.02.2015**
(21) Anmeldenummer: 13180737.2
(22) Anmeldetag: 16.08.2013
(51) Int. Cl.: H01L 23/522, H03K 19/00, H03F 19/00, H04B 3/30

(54) **Integrierter Schaltkreis**

(71) Anmelder: Siemens Aktiengesellschaft, 80333 München (DE)
(72) Erfinder: Griessbach, Gunter, 09423 Gelenau (DE)

(57) **Zusammenfassung**

Die Erfindung betrifft einen integrierten Schaltkreis (100) mit einem ersten Schaltkreis (101) und einem zweiten Schaltkreis (102), welche zum Informationsaustausch über eine erste Leiterschleife (11) und eine zweite Leiterschleife (12) galvanisch getrennt mit einander verbunden sind. Erfindungsgemäß ist vorgesehen, dass die erste Leiterschleife (11) in einer ersten Schicht (21) angeordnet ist und die zweite Leiterschleife (12) in einer zweiten Schicht (22) angeordnet ist, wobei die erste Leiterschleife (11) in einen ersten Leiterschleifenteil (11a) und einen zweiten Leiterschleifenteil (11b) und die zweite Leiterschleife (12) in einen dritten Leiterschleifenteil (12a) und einen vierten Leiterschleifenteil (12b) aufgeteilt ist, wobei der erste Leiterschleifenteil (11a) mit dem zweiten Leiterschleifenteil (11b) derart verschaltet ist, dass eine Feldrichtung eines Feldes von dem ersten Leiterschleifenteil (11a) entgegengesetzt zu einer Feldrichtung eines Feldes von dem zweiten Leiterschleifenteil (11b) ausgerichtet ist, dabei ist der dritte Leiterschleifenteil (12a) mit dem vierten Leiterschleifenteil (12b) in der gleichen Art verschaltet.

## Beschreibung

Die Erfindung betrifft einen integrierten Schaltkreis mit einem ersten Schaltkreis und einem zweiten Schaltkreis, welche zum Informationsaustausch über eine erste Leiterschleife und eine zweite Leiterschleife galvanisch getrennt mit einander verbunden sind.

Zur galvanischen Trennung sind beispielsweise Anordnungen bekannt, bei welchen übereinander liegende Luftspulen eingesetzt werden, welche durch eine magnetische Verkopplung eine Signalübertragung erlauben. Ein Treiber steuert dabei beispielsweise eine Primärspule, die in eine Sekundärspule eine Spannung induziert, welche durch eine nachfolgende Elektronik aufbereitet und verstärkt wird um die erforderlichen Pegel zu erreichen. Üblich ist es, Differenzsignale zu übertragen. Dazu erhalten die Übertrager, also die erste Leiterschleife und die zweite Leiterschleife, je einen Mittelabgriff, welcher einen Massebezug herstellt oder auf ein Mittenpotenzial bezogen ist.

Gleichtaktsignale sollten nicht übertragen werden, aber bedingt durch eine Kapazität zwischen der ersten Leiterschleife und der zweiten Leiterschleife kann es zusätzlich zur Übertragung von Gleichtaktanteilen kommen. Es ist wünschenswert bei einer Signalübertragung auf der Sekundärseite ein "sauberes" Nutzsignal zu erhalten. Werden hingegen durch äußere Stör-Wechselfelder, beispielsweise gepulste Magnetfelder, Störungen in die Leiterschleife oder in die Zuleitungen zu den Leiterschleifen eingekoppelt, kommt es auf der Sekundärseite zu Störspannungen, die nachfolgend noch verstärkt werden oder auch die Verstärkerelektronik in ihrer Funktion beeinträchtigen können. Beides führt zu fehlerhaften Signalen auf der Sekundärseite.

Es ist Aufgabe der vorliegenden Erfindung einen integrierten Schaltkreis bereitzustellen, welcher gegenüber den bekannten integrierten Schaltkreisen eine erhöhte Störfestigkeit im Hinblick auf EMV-Störungen aufweist.

Bei dem eingangs genannten integrierten Schaltkreis wird die Aufgabe dadurch gelöst, dass die erste Leiterschleife in einer ersten Schicht angeordnet ist und die zweite Leiterschleife in einer zweiten Schicht angeordnet ist, wobei die erste Leiterschleife in einen ersten Leiterschleifenteil und einen zweiten Leiterschleifenteil und die zweite Leiterschleife in einen dritten Leiterschleifenteil und einen vierten Leiterschleifenteil aufgeteilt ist, wobei der erste Leiterschleifenteil mit dem zweiten Leiterschleifenteil derart verschaltet ist, dass eine Feldrichtung eines Feldes von dem ersten Leiterschleifenteil entgegengesetzt zu einer Feldrichtung eines Feldes von dem zweiten Leiterschleifenteil ausgerichtet ist, dabei ist der dritte Leiterschleifenteil mit dem vierten Leiterschleifenteil in der gleichen Art verschaltet.

Die störenden Auswirkungen von Einkopplungen von externen Störfeldern (Wechselmagnetfeldern, gepulste Magnetfelder) werden verhindert, indem die Leiterschleifenteile einer jeden Leiterschleife gegensinnig miteinander verschaltet sind. Eingekoppelte Störspannungen in die Leiterschleifenteile heben sich bedingt durch die gegensätzliche Verschaltung auf. Ein Nutzsignal hingegen wird ungehindert übertragen, da die erste Leiterschleife und die zweite Leiterschleife (Primär- und Sekundärseite) gleichartig aufgebaut sind. Mit der sozusagen gegensinnigen Verschaltung des ersten Leiterschleifenteils mit dem zweiten Leiterschleifenteil bzw. des dritten Leiterschleifenteils mit dem vierten Leiterschleifenteil werden mit dieser Anordnung externe Störeinflüsse kompensiert.

Zur Übertragung von Differenzsignalen weisen der zweite Leiterschleifenteil und der dritte Leiterschleifenteil je einen Mittenabgriff auf.

Vorzugsweise sind die Leiterschleifen durch eine strukturierte Bahn innerhalb eines Substrates gebildet.

Weiterhin ist es vorteilhaft, wenn der erste Leiterschleifenteil über den dritten Leiterschleifenteil angeordnet ist und der zweite Leiterschleifenteil über dem vierten Leiterschleifenteil angeordnet ist.

Zur Signalankopplung weist der erste Leiterschleifenteil einen ersten und einen zweiten Anschluss als Informationssignaleingang auf und der vierte Leiterschleifenteil weist einen dritten und einen vierten Anschluss als Informationssignalausgang auf.

Zur Reduzierung von kapazitiven Verkopplungen der ersten Leiterschleife mit der zweiten Leiterschleife ist vorzugsweise zwischen der ersten und der zweiten Schicht eine Schirmschicht angeordnet, wobei die Schirmschicht eine erste Freifläche, eine zweite Freifläche und eine Randfläche aufweist, wobei oberhalb bzw. unterhalb der ersten Freifläche der erste bzw. dritte Leiterschleifenteil und oberhalb bzw. unterhalb der zweiten Freifläche der zweite bzw. vierte Leiterschleifenteil angeordnet ist. Vorteilhafterweise ist innerhalb der Randfläche eine Aussparung angeordnet, welche dazu dient, dass die Schirmschicht nicht eine Kurzschlusswindung bildet. Von weiterem Vorteil ist es, wenn in der Freifläche zusätzlich Ringe mit Öffnungen angeordnet sind, welche sich annähernd in Deckung mit den ersten Leiterschleifenteil bzw. den dritten Leiterschleifenteil befinden. Die Ringe weisen ebenfalls Öffnungen auf, damit keine Kurzschlusswindung gebildet wird.

Eine weitere Erhöhung der Störfestigkeit wird erreicht, wenn die Schirmschicht elektrisch leitend an zumindest einen der Mittenabgriffe angeschlossen ist. Will man den integrierten Schaltkreis bevorzugt in Automatisierungskomponenten von Industrieanlagen, insbesondere für den Betrieb von Ein-/Ausgabe-Baugruppen einsetzen, so ist der integrierte Schaltkreis mit Vorteil als ein mehrkanaliger Ein- und/oder Ausgangshalbleiterbaustein für einen Einsatz in der industriellen Automatisierungstechnik ausgestaltet, wobei der erste Schaltkreis als eine Logik-Schaltung zur Weitergabe von Ein- und/oder Ausgangssignalpegeln an einen Mikrocontroller und der zweite Schaltkreis als eine Steuer- und Schutz-Schaltung zum Empfangen bzw. Ausgeben von Schaltzuständen von Prozesssignalen eines industriellen Automatisierungsprozesses ausgestaltet ist.

Die Zeichnung zeigt ein Ausführungsbeispiel einer ersten Leiterschleife und einer zweiten Leiterschleife, angeordnet als Übertrager, zum Einsatz in einen integrierten Schaltkreis.

Es zeigt die
- FIG 1: die erfindungsgemäße Anordnung der Leiterschleifen bzw. der Leiterschleifenteile zur Kompensation der Störwirkung externer Felder, die
- FIG 2: eine Schirmschicht, die
- FIG 3: einen Schichtenaufbau, die
- FIG 4: eine Erweiterung der FIG 1 mit Anschlussleitungen zu den Leiterschleifen, die
- FIG 5: einen prinzipiellen Aufbau des integrierten Schaltkreises und die
- FIG 6: eine alternative Ausgestaltung einer Leiterschleifenanordnung.

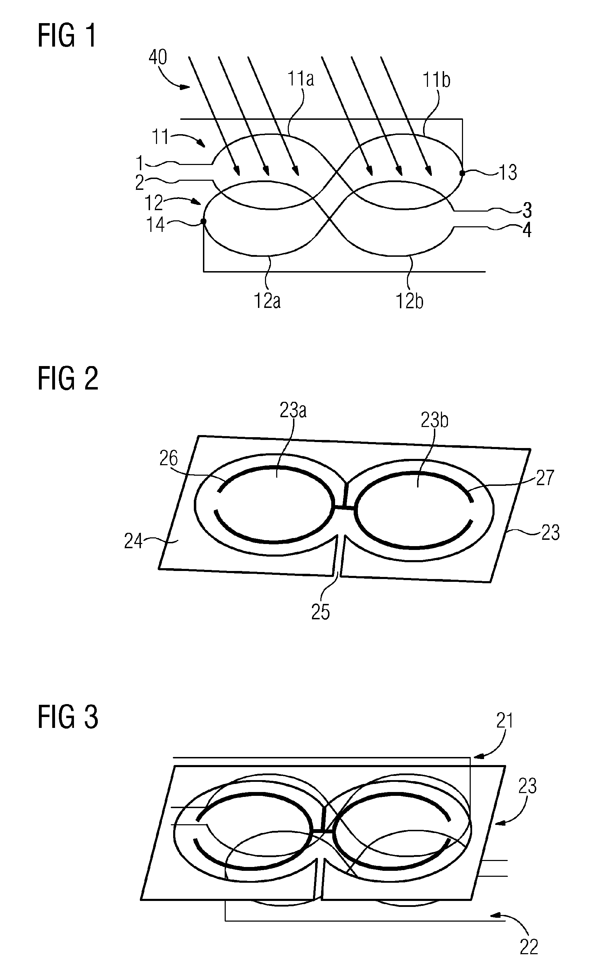

Gemäß der FIG 1 ist eine erste Leiterschleife 11 über einer zweiten Leiterschleife 12 derart angeordnet, dass dadurch ein kernloser Übertrager gebildet ist. Die Anordnung wird von einem Störfeld 40 durchsetzt. Zur Kompensation der störenden Wirkung des Störfeldes 40 weist die erste Leiterschleife 11 einen ersten Leiterschleifenteil 11a und einen zweiten Leiterschleifenteil 11b und die zweite Leiterschleife 12 einen dritten Leiterschleifenteil 12a und einen vierten Leiterschleifenteil 12b auf. Der erste Leiterschleifenteil 11a ist mit dem zweiten Leiterschleifenteil 11b derart verschaltet, dass eine Feldrichtung eines Feldes, hervorgerufen durch einen Stromfluss durch die Leiterschleife, von dem ersten Leiterschleifenteil 11a entgegengesetzt zu einer Feldrichtung eines Feldes von dem zweiten Leiterschleifenteil 11b ausgerichtet ist, dabei ist der dritte Leiterschleifenteil mit dem vierten Leiterschleifenteil in der gleichen Art verschaltet.

Die von dem Störfeld 40 durchsetzten Teilflächen der Leiterschleifenteile 11a,11b sollten annähernd gleich groß gewählt sein. Wählt man als ersten Leiterschleifenteil 11a einen ersten Teilring und als zweiten Leiterschleifenteil 11b einen zweiten Teilring, so sind die Teilringe vorzugsweise nebeneinander angeordnet und an einem theoretischen Berührpunkt der Teilringe weisen diese Teilringe zum Verbinden der Teilringe Öffnungen auf, welche über Brücken, welche beispielsweise in einer Schicht eines Halbleiters durchkontaktiert werden, miteinander die gegensinnige Verschaltung erfahren.

Als ein Informationssignaleingang weist der erste Leiterschleifenteil 11a einen ersten Anschluss 1 und einen zweiten Anschluss 2 auf. Als Informationssignalausgang weist der vierte Leiterschleifenteil einen dritten Anschluss 3 und einen vierten Anschluss 4 auf. Für die Übertragung von Differenzsignalen weist die erste Leiterschleife 11 in ihrem ersten Leiterschleifenteil 11a einen ersten Mittenabgriff 13 und die zweite Leiterschleife 12 in ihrem dritten Leiterschleifenteil 12a einen zweiten Mittenabgriff 13 auf.

Zur Reduzierung von kapazitiven Verkopplungen der ersten Leiterschleife 11 mit der zweiten Leiterschleife 12 können zum einen die erste Leiterschleife 11 und die zweite Leiterschleife 12 gegeneinander versetzt angeordnet sein, so dass sich die Leiterzüge nicht mehr direkt gegenüberstehen. Zum anderen kann eine Schirmschicht 23 zwischen die erste Leiterschleife 11 und die zweite Leiterschleife 12 eingebracht werden.

Gemäß FIG 2 ist eine Schirmschicht 23 mit einer ersten Freifläche 23a, einer zweiten Freifläche 23b und einer Randfläche 24 dargestellt. Die Randfläche 24 weist eine Ausnehmung 25 auf. Die erste Freifläche 23a weist einen ersten Ring 26 und die zweite Freifläche 23b weist einen zweiten Ring 27 auf. Die Ausnehmung 25 in der Randfläche 24 dient dazu, dass die Schirmschicht 23 nicht eine Kurzschlusswindung bildet. Ebenso dienen Öffnungen in dem ersten Ring 26 und dem zweiten Ring 27 dazu, dass eine Kurzschlusswindung verhindert wird.

Die Schirmschicht 23 ist als eine zu den Leiterschleifen (11a,11b bzw. 12a,12b) deckungsgleichen Leiterstruktur, umfassend den ersten Ring 26 und den zweiten Ring 27, ausgestaltet. Die Ringe 26,27 liegen dabei nebeneinander und sind ungefähr in der Mitte der Schirmschicht 23 miteinander elektrisch verbunden, wobei auch die Randfläche 24 an einer Stelle in der Mitte mit den Ringen 26,27 elektrisch verbunden ist. Die Ausnehmung 25 in der Randfläche 24 bildet einen Spalt, durch den sich die Leiterschleifenteile 11a und 11b mit den korrespondierenden Leiterschleifenteilen 12a und 12b magnetisch doppeln können.

Die FIG 3 zeigt einen geschichteten Aufbau aus der ersten Leiterschleife 11, der Schirmschicht 23 und der zweiten Leiterschleife 12. Demnach ist die erste Leiterschleife 11 in einer ersten Schicht 21 angeordnet und die zweite Leiterschleife 12 ist in einer zweiten Schicht 22 angeordnet, wobei zwischen der ersten und der zweiten Schicht 21,22 die Schirmschicht 23 angeordnet ist. Oberhalb bzw. unterhalb der ersten Freifläche 23a (siehe FIG 2) ist der erste bzw. dritte Leiterschleifenteil 11a,12a und oberhalb bzw. unterhalb der zweiten Freifläche 23b (siehe FIG 2) ist der zweite bzw. vierte Leiterschleifenteil 11b,12b angeordnet.

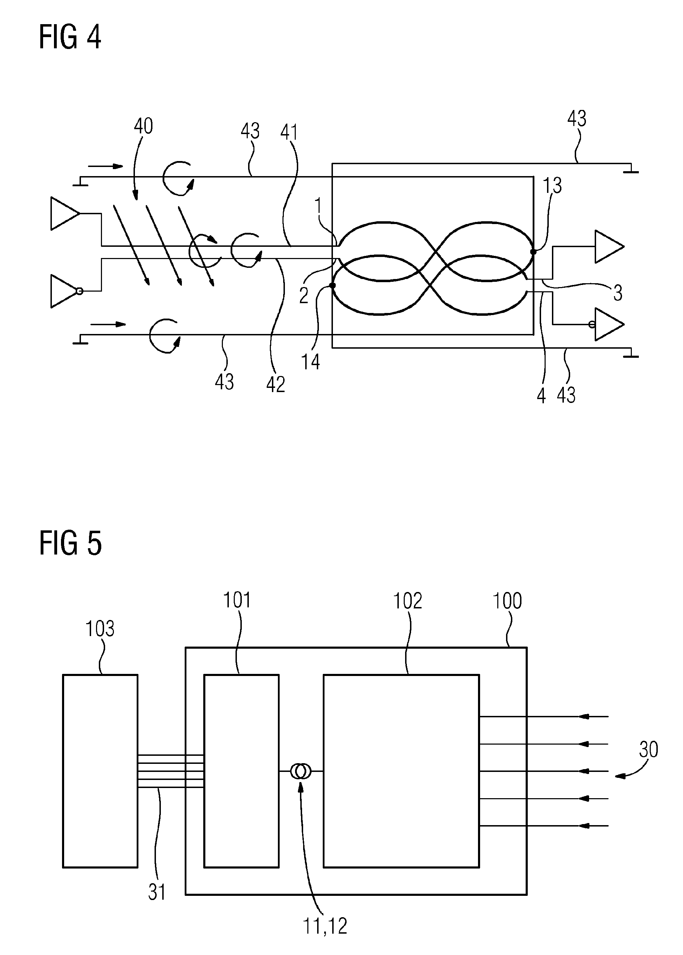

Um eine Störfestigkeit weiterhin zu erhöhen ist mit der FIG 4 eine Führung von Anschlussleitungen zu der ersten Leiterschleife 11 und der zweiten Leiterschleife 12 dargestellt. Eine erste Anschlussleitung 41 verbindet einen Treiberbaustein mit dem ersten Anschluss 1 der ersten Leiterschleife 11. Eine zweite Anschlussleitung 42 verbindet einen Treiberbaustein mit einem invertierenden Ausgang, mit dem zweiten Anschluss 2 der ersten Leiterschleife 11. Die erste Anschlussleitung 41 und die zweite Anschlussleitung 42 und auch eine Masseleitung 43 können, insbesondere bei der Ausgestaltung eines integrierten Schaltkreises, als so genannte Bonddrähte ausgeführt sein. Die Führung der ersten und zweiten Anschlussleitung 41,42 ist derart ausgeführt, dass sich die erste und zweite Anschlussleitung möglichst dicht beieinander befinden, damit sich auch hier induzierte Störspannungen aufheben. Dadurch, dass die Masseleitung 43 zum einen an den ersten Mittenabgriff 13 angeschlossen ist und zum anderen an den zweiten Mittenabgriff 14 angeschlossen ist, bilden sich in einer Schichtaufbauweise ebenfalls zwei "Masseleiterschleifen", welche vorzugsweise die gleichen Flächen haben sollten, damit ein eventueller Strom, welcher durch die Masseleitungen fließt, zu Feldern führen würde, welche sich in den Signalleitungen aufheben. Der Aufbau muss dazu exakt symmetrische ausgelegt sein.

Die FIG 5 zeigt einen integrierten Schaltkreis 100 mit einem ersten Schaltkreis 101 und einem zweiten Schaltkreis 102, welche zum Informationsaustausch über die erste Leiterschleife 11 und die zweite Leiterschleife 12 galvanisch getrennt miteinander verbunden sind. Der integrierte Schaltkreis 100 weist Prozesssignaleingänge 30 auf. Diese Prozesssignaleingänge 30 werden auf den zweiten Schaltkreis 102 geführt, welcher als eine Steuer- und Schutzschaltung zum Empfangen bzw. Ausgeben von Schaltzuständen der Prozesssignale 30 ausgestaltet ist. Der erste Schaltkreis 101 ist als eine Logik-Schaltung zur Weitergabe von Ein- und/oder Ausgangssignalpegeln ausgestaltet und mit einem Mikrocontroller 103 verbunden. Die Verbindung zwischen dem Mikrocontroller 103 und dem ersten Schaltkreis 101 ist über eine Kommunikationsverbindung, vorzugsweise einen Parallelbus 31, realisiert.

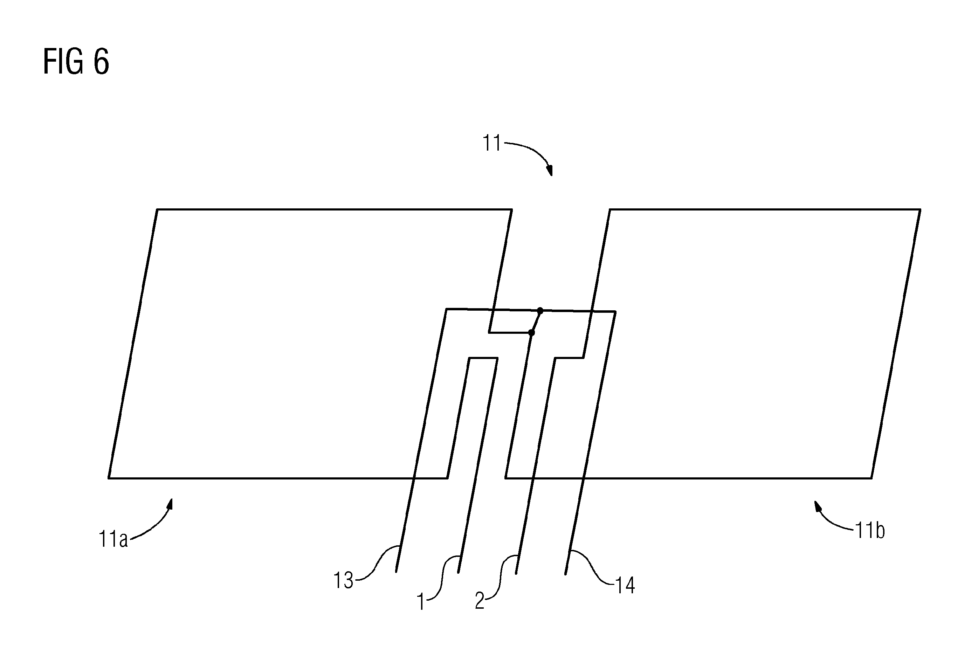

Mit der FIG 6 wird eine alternative Anordnung der ersten Leiterschleife 11 vorgestellt. Die erste Leiterschleife 11 ist wiederum in einem ersten Leiterschleifenteil 11a und einem zweiten Leiterschleifenteil 11b ausgeführt. Die Leiterschleifenteile 11a,11b haben eine annähernd rechteckige Form, wobei der erste Anschluss 1 und der zweite Anschluss 2 in einer unmittelbaren Umgebung einer gedachten Symmetrielinie zwischen dem ersten Leiterschleifenteil 11a und dem zweiten Leiterschleifenteil 11b angeordnet sind. Der erste Mittenabgriff 13 und der zweite Mittenabgriff 14 befinden sich ebenfalls in Nähe der Symmetrielinie und sind zusammengeführt an einen Mittelpunkt, welcher sich aus der Mitte der ersten Leiterschleife 11a und der zweiten Leiterschleife 11b ergibt.

## Patentansprüche

1. Integrierter Schaltkreis (100) mit einem ersten Schaltkreis (101) und einem zweiten Schaltkreis (102), welche zum Informationsaustausch über eine erste Leiterschleife (11) und eine zweite Leiterschleife (12) galvanisch getrennt mit einander verbunden sind,
**dadurch gekennzeichnet, dass** die erste Leiterschleife (11) in einer ersten Schicht (21) angeordnet ist und die zweite Leiterschleife (12) in einer zweiten Schicht (22) angeordnet ist, wobei die erste Leiterschleife (11) in einen ersten Leiterschleifenteil (11a) und einen zweiten Leiterschleifenteil (11b) und die zweite Leiterschleife (12) in einen dritten Leiterschleifenteil (12a) und einen vierten Leiterschleifenteil (12b) aufgeteilt ist, wobei der erste Leiterschleifenteil (11a) mit dem zweiten Leiterschleifenteil (11b) derart verschaltet ist, dass eine Feldrichtung eines Feldes von dem ersten Leiterschleifenteil (11a) entgegengesetzt zu einer Feldrichtung eines Feldes von dem zweiten Leiterschleifenteil (11b) ausgerichtet ist, dabei ist der dritte Leiterschleifenteil (12a) mit dem vierten Leiterschleifenteil (12b) in der gleichen Art verschaltet.

2. Integrierter Schaltkreis (100) nach Anspruch 1, wobei der zweite Leiterschleifenteil (11b) und der dritte Leiterschleifenteil (12a) je einen Mittenabgriff (13,14) aufweisen.

3. Integrierter Schaltkreis (100) nach Anspruch 1 oder 2, bei dem die Leiterschleifen (11,12) durch eine strukturierte Bahn innerhalb eines Substrates gebildet sind.

4. Integrierter Schaltkreis (100) nach einem der Ansprüche 1 bis 3, wobei der erste Leiterschleifenteil (11a) über den dritten Leiterschleifenteil (12a) angeordnet ist und der zweite Leiterschleifenteil (11b) über dem vierten Leiterschleifenteil (12b) angeordnet ist.

5. Integrierter Schaltkreis (100) nach einem der Ansprüche 1 bis 4, bei dem der erste Leiterschleifenteil (11a) einen ersten und einen zweiten Anschluss (1,2) als Informationssignaleingang und der vierte Leiterschleifenteil (12b) einen dritten und vierten Anschluss (3,4) als Informationssignalausgang aufweist.

6. Integrierter Schaltkreis (100) nach einem der Ansprüche 1 bis 5, wobei zwischen der ersten und der zweiten Schicht (21,22) eine Schirmschicht (23) angeordnet ist, wobei die Schirmschicht (23)
eine erste Freifläche (23a),
eine zweite Freifläche (23b) und
eine Randfläche (24) aufweist,
wobei oberhalb bzw. unterhalb der ersten Freifläche (23a) der erste bzw. dritte Leiterschleifenteil (11a,12a) und
oberhalb bzw. unterhalb der zweiten Freifläche (23b) der zweite bzw. vierte Leiterschleifenteil (11b,12b) angeordnet ist.

7. Integrierter Schaltkreis (100) nach Anspruch 6, wobei die Schirmschicht (23) elektrisch leitend an zumindest einen der Mittenabgriffe (13,14) angeschlossen ist.

8. Integrierter Schaltkreis (100) nach einem der Ansprüche 1 bis 7, ausgestaltet als ein mehrkanaliger Ein- und/oder Ausgangs Halbleiterbaustein für einen Einsatz in der industriellen Automatisierungstechnik, wobei der erste Schaltkreis (101) als eine Logik-Schaltung zur Weitergabe von Ein- und/oder Ausgangssignalpegeln an einen Mikrocontroller (103) und der zweite Schaltkreis (102) als eine Steuer- und Schutzschaltung zum Empfangen bzw. Ausgeben von Schaltzuständen von Prozesssignalen eines industriellen Automatisierungsprozess.
